Europäisches Patentamt

European Patent Office

Office européen des brevets

(19)

(11) **EP 0 743 816 B1**

(12) **FASCICULE DE BREVET EUROPEEN**

(45) Date de publication et mention
de la délivrance du brevet:
**01.07.1998 Bulletin 1998/27**

(51) Int Cl.6: **H05K 7/14**

(21) Numéro de dépôt: **96400959.1**

(22) Date de dépôt: **06.05.1996**

(54) **Dispositif électronique protégé contre les chocs par capsulation**

Stossgeschützte elektronische Vorrichtung durch Einkapsulierung

Shocks protected electronic device by encapsulation

(84) Etats contractants désignés:
**BE CH DE ES GB GR IT LI NL PT SE**

(30) Priorité: **18.05.1995 FR 9505907**

(43) Date de publication de la demande:
**20.11.1996 Bulletin 1996/47**

(73) Titulaire: **AEROSPATIALE SOCIETE NATIONALE
INDUSTRIELLE
75016 Paris (FR)**

(72) Inventeurs:
• **Lacroix, Marc
F-91410 Dourdan (FR)**

• **Bouyon, Claude
92320 Chatillon (FR)**

(74) Mandataire: **Bonnetat, Christian
CABINET BONNETAT
29, rue de St. Pétersbourg
75008 Paris (FR)**

(56) Documents cités:
**WO-A-87/06091        US-A- 4 823 700
US-A- 5 285 559**

• **ELECTRONICS INT., vol. 50, no. 17, Août 1977,
NEW YORK, US, pages 50,52--, XP002012241
"Rigid assembly takes cannon-launch g "**

# Description

La présente invention concerne un dispositif électronique comportant un ensemble de plaquettes porteuses de composants électroniques, susceptible de résister à des chocs à haute énergie dans une direction déterminée, ainsi qu'un procédé pour réaliser ledit dispositif électronique.

Bien que non exclusivement, la présente invention est particulièrement bien appropriée à des dispositifs d'enregistrement montés sur un engin mobile, en particulier un aéronef, et susceptibles d'être soumis à des contraintes physiques très élevées, notamment lors d'un choc dudit engin.

De tels dispositifs d'enregistrement associés par exemple à un aéronef, qui enregistrent des données au cours du vol de l'aéronef et/ou au moment d'un choc provoqué ou non de celui-ci, doivent être conçus pour résister aux contraintes thermiques et surtout mécaniques engendrées lors dudit choc et susceptibles d'être très élevées, afin de pouvoir restituer les informations enregistrées.

De tels dispositifs d'enregistrement sont notamment utilisés pour effectuer des enregistrements lors d'essais en vol, en particulier des essais de missiles effectués par exemple lors du développement d'un système d'armes utilisant de tels missiles.

Les dispositifs d'enregistrement, et plus généralement les dispositifs électroniques, envisagés ici comportent un ensemble de plaquettes planes porteuses de composants électroniques, montées de façon écartée et parallèlement les unes par rapport aux autres.

De façon connue, ces plaquettes, généralement de même forme circulaire, sont reliées ensemble par une pluralité de tiges métalliques rigides, orthogonales aux plans des plaquettes et uniformément réparties près de la périphérie externe desdites plaquettes, lesdites tiges métalliques assurant parfois également une liaison électrique entre les plaquettes.

Toutefois, une telle solution de montage est très coûteuse et, de plus, elle n'est guère satisfaisante lors d'un choc prévu généralement dans une direction orthogonale aux plans desdites plaquettes, puisque :

- d'une part, toutes les contraintes engendrées lors d'un tel choc doivent être absorbées par la structure décrite précédemment, qui est uniquement rigide et non élastique ; et
- d'autre part, bien que les tiges métalliques assurent une tenue mécanique relativement bonne des plaquettes, notamment sur la périphérie externe de ces dernières, les composants électroniques montés sur ces plaquettes ne sont nullement retenus par des moyens spécifiques et sont donc insuffisamment fixés pour les opérations envisagées, de sorte qu'il existe un risque important d'arrachement ou de détérioration de ces composants électroniques.

Par ailleurs, ces composants électroniques ne sont pas non plus protégés contre d'autres contraintes non mécaniques, comme par exemple des contraintes dues à l'environnement, en particulier des contraintes thermiques.

La présente invention a pour objet de remédier à ces inconvénients. Elle concerne un dispositif électronique comportant un ensemble de plaquettes porteuses de composants électroniques, montées de façon écartée et parallèlement les unes par rapport aux autres, ledit dispositif électronique étant susceptible de résister à des chocs dans une direction déterminée, approximativement orthogonale aux plans desdites plaquettes, ainsi qu'à des contraintes très défavorables de l'environnement.

A cet effet, ledit dispositif électronique est remarquable selon l'invention en ce qu'il comporte un corps protecteur en matière élastomère enrobant ledit ensemble de plaquettes, ladite matière élastomère remplissant tous les espaces entre lesdites plaquettes et formant au moins un bouclier avant, dans le sens des chocs, pour ledit ensemble de plaquettes.

Ainsi, grâce audit bouclier avant et aux qualités élastiques de la matière élastomère, ledit corps protecteur est susceptible d'amortir des chocs à très haute énergie, et ainsi de protéger ledit ensemble de plaquettes contre des contraintes mécaniques très élevées.

Comme, de plus, la matière élastomère dudit corps protecteur remplit tous les espaces entre lesdites plaquettes et enrobe donc tous les composants électroniques montés sur lesdites plaquettes, il n'existe aucun risque d'arrachement ou de détérioration desdits composants électroniques, contrairement aux dispositifs connus précités.

En outre, ledit corps protecteur en matière élastomère présente de nombreux autres avantages, en particulier :

- il est étanche, ce qui procure une protection efficace notamment contre l'eau et la poussière ; et
- il présente une bonne résistance thermique sur des échelles de températures très larges.

Comme par ailleurs la présente invention peut être mise en oeuvre sur tout dispositif électronique conforme au préambule, elle présente l'avantage de pouvoir être utilisée dans une multiplicité d'applications possibles.

De façon avantageuse, ladite matière élastomère forme de plus un bouclier arrière pour ledit ensemble de plaquettes, ce qui permet de protéger ledit ensemble de plaquettes contre un éventuel choc incident vers l'arrière, dû à un effet de rebond.

Avantageusement, ledit corps protecteur présente une forme générale cylindrique ou parallélépipédique.

Pour la réalisation dudit corps protecteur, on utilise de préférence, comme matière élastomère, de la silicone. La silicone présente l'avantage d'être ininflammable ; en cas de feu (surchauffe), elle résiste à 3000°C pendant quelques secondes et sa conductibilité thermique est de 0,23 W/m/°K. Avantageusement, la silicone peut de plus être au moins partiellement transparente, ce qui permet au moins un contrôle visuel approximatif dudit ensemble de plaquettes.

En outre, de façon avantageuse, les boucliers avant et arrière dudit corps protecteur présentent des évidements périphériques, de préférence de forme conique, ce qui crée des espaces permettant une expansion de la matière élastomère lors d'un choc entraînant une déformation dudit corps protecteur.

Par ailleurs, ledit dispositif électronique comporte avantageusement au moins une pièce auxiliaire, par exemple une rondelle, en nid d'abeille, montée à l'avant du corps protecteur dans le sens des chocs. L'écrasement de ladite pièce auxiliaire lors d'un choc contribue également à l'amortissement, notamment en permettant d'augmenter le temps d'arrêt du corps protecteur et en diminuant ainsi les contraintes de choc induites.

Bien entendu, le dispositif électronique conforme à l'invention peut être directement monté dans un logement de forme adaptée, prévu sur l'engin destiné à être équipé dudit dispositif électronique.

Toutefois, dans un mode de réalisation particulièrement avantageux de l'invention, ledit corps protecteur est entouré d'une enveloppe rigide, réalisée de préférence en un matériau composite et destinée à être rendue solidaire dudit engin, ce qui permet, d'une part, de conférer une protection latérale audit dispositif électronique et, d'autre part, de favoriser l'amortissement lors d'un choc en raison du frottement existant alors entre ledit corps protecteur et ladite enveloppe rigide.

Cette enveloppe rigide permet en outre de simplifier la réalisation du dispositif électronique conforme à l'invention, en permettant la mise en oeuvre d'un procédé de réalisation avantageux conforme à l'invention, et précisé ci-dessous.

La présente invention concerne en effet également un procédé pour réaliser le dispositif électronique précité.

A cet effet, ledit procédé est remarquable selon l'invention en ce que :

- on introduit ledit ensemble de plaquettes dans ladite enveloppe rigide munie d'ouvertures réparties le long de sa direction longitudinale ;
- on bouche les extrémités de ladite enveloppe rigide ;
- on fait couler une matière élastomère à l'intérieur de ladite enveloppe rigide à travers lesdites ouvertures de sorte que ladite matière élastomère enrobe ledit ensemble de plaquettes et remplit les espaces entre lesdites plaquettes ; et
- on solidifie ladite matière élastomère formant ainsi ledit corps protecteur et au moins ledit bouclier avant.

Ainsi, grâce à l'invention, ledit corps protecteur peut être réalisé de façon très simple et il est monté directement à l'intérieur de l'enveloppe rigide associée.

Les figures du dessin annexé feront bien comprendre comment l'invention peut être réalisée. Sur ces figures, des références identiques désignent des éléments semblables.

La figure 1 est une coupe longitudinale schématique d'un dispositif électronique conforme à l'invention réalisé selon un premier mode de réalisation.

La figure 2 est une coupe longitudinale schématique d'un dispositif électronique conforme à l'invention réalisé selon un second mode de réalisation.

La figure 3 est une coupe partielle du dispositif électronique conforme à l'invention selon la ligne III-III de la figure 2.

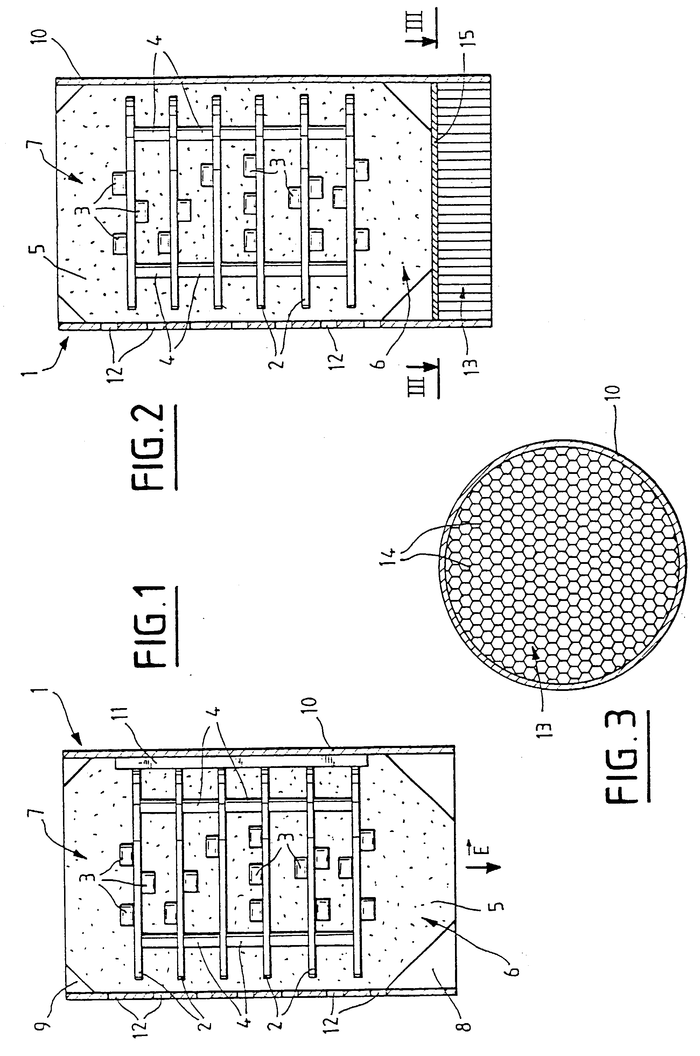

La présente invention est appliquée à un dispositif électronique 1 représenté schématiquement dans un premier mode de réalisation sur la figure 1.

Ledit dispositif électronique 1 comporte un ensemble de plaquettes 2, circulaires et planes, portant des composants électroniques 3 représentés schématiquement sur la figure 1.

Lesdites plaquettes 2 sont montées parallèlement les unes par rapport aux autres en étant écartées les unes des autres par des entretoises 4 réparties uniformément à proximité de la périphérie desdites plaquettes 2.

Selon le mode de réalisation prévu, lesdites entretoises 4 sont :

- soit fixées individuellement sur les plaquettes respectivement adjacentes ;
- soit de forme creuse et fixées ensemble le long d'une direction longitudinale par une tige traversante non représentée et uniquement solidarisée, par exemple par vis, au niveau des plaquettes extrêmes dudit ensemble de plaquettes.

Ledit dispositif électronique 1 est réalisé de manière à pouvoir résister à des chocs violents dans une direction de choc déterminée $\vec{E}$, approximativement orthogonale aux plans desdites plaquettes 2.

A cet effet, ledit dispositif électronique 1 comporte, selon l'invention, un corps protecteur 5 en matière élastomère de forme générale cylindrique, enrobant ledit ensemble de plaquettes 2 et de composants électroniques 3, ladite matière élastomère remplissant les espaces entre lesdites plaquettes 2 et formant au moins un bouclier avant 6, dans le sens des chocs $\vec{E}$, pour ledit ensemble de plaquettes 2.

Ledit corps protecteur 5 présente de très nombreux avantages, en particulier :

- il est susceptible d'amortir, grâce audit bouclier avant 6 et aux qualités élastiques de la matière élastomère, des chocs très violents et ainsi de protéger ledit ensemble de plaquettes 2 contre des contraintes mécaniques très élevées, par exemple des vibrations aléatoires de 10 à 3000 Hz à 21 geff (geff représentant l'accélération efficace de la pesanteur) et des chocs mécaniques de 3500 g (g représentant l'accélération de la pesanteur) en 0,5 ms, pour une masse du dispositif électronique inférieure à 1 kg ;

- il présente une bonne résistance thermique sur une échelle de températures très large, par exemple -70°C à plus de +200°C en continu (quelques heures) ;

- il est étanche, ce qui confère une protection efficace contre l'eau, la poussière, ... ; et

- il empêche tout risque d'arrachement ou de détérioration par déplacement desdits composants électroniques 3, puisque lesdits composants électroniques 3 sont enrobés conjointement avec les plaquettes 2 par ladite matière élastomère.

De préférence, on utilise de la matière élastomère, par exemple de la silicone, au moins partiellement transparente, ce qui permet d'effectuer un contrôle visuel approximatif dudit ensemble de plaquettes 2 et notamment de connaître les positions respectives desdites plaquettes 2.

Comme de plus la matière élastomère, notamment la silicone, peut généralement être recollée, il est envisageable avec la présente invention de découper le corps protecteur 5, après une première utilisation, en rondelles cylindriques comportant chacune au moins une plaquette 2, et ensuite de recoller ensemble uniquement les plaquettes 2 utiles à une seconde utilisation et/ou de modifier les positions respectives de ces plaquettes 2, ce qui est particulièrement avantageux et économique puisqu'on peut ainsi utiliser les mêmes plaquettes pour d'autres applications.

Comme on peut le voir sur la figure 1, ledit corps protecteur 5 comporte en outre un bouclier arrière 7, moins large que le bouclier avant 6 et destiné à protéger ledit ensemble de plaquettes 2 contre un éventuel choc incident vers l'arrière, dû à un effet de rebond.

Lesdits boucliers avant et arrière 6 et 7 présentent des évidements périphériques 8 et 9, de forme conique croissant vers l'extérieur, destinés à permettre une expansion de la matière du corps protecteur 5 lors d'un choc entraînant une déformation dudit corps protecteur 5.

On notera qu'à cet effet l'évidement 8 est plus important que l'évidement 9, puisque ledit évidement 8 est destiné au choc initial vers l'avant et l'évidement 9 à un éventuel choc incident vers l'arrière, dû à un effet de rebond.

On notera par ailleurs que l'alimentation électrique non représentée du dispositif électronique 1 peut être prévue de différentes manières laissées à l'appréciation de l'homme du métier en fonction de l'application envisagée. On peut par exemple prévoir une batterie ou une pile thermique qui est, soit incorporée dans le corps protecteur 5, soit située à l'extérieur dudit corps protecteur 5 et reliée à l'ensemble de plaquettes 2 par une liaison électrique.

En outre, le dispositif électronique 1 conforme à l'invention comporte une enveloppe rigide 10, de préférence en un matériau composite, par exemple en carbone epoxy, de forme cylindrique creuse entourant ledit corps protecteur 5.

Ladite enveloppe rigide 10 permet de conserver l'intégrité mécanique du dispositif électronique 1 qui dispose ainsi d'un degré de liberté dans le sens de la flèche $\vec{E}$ pour amortir des chocs.

Cette enveloppe rigide 10 est destinée à être rendue solidaire de l'engin, par exemple un aéronef, qui doit être équipé dudit dispositif électronique 1.

Les frottements apparaissant entre ladite enveloppe rigide 10 et ledit corps protecteur 5 lors d'un choc contribuent également à favoriser l'amortissement.

On remarquera que, dans un autre mode de réalisation non représenté, ledit corps protecteur 5 peut être directement monté ou moulé dans un logement adapté prévu dans ledit engin.

Toutefois, ladite enveloppe rigide 10 présente un autre avantage important. Elle contribue à faciliter la réalisation dudit corps protecteur 5, en permettant la mise en oeuvre d'un procédé conforme à l'invention prévu à cet effet.

Selon ledit procédé conforme à l'invention, on effectue les opérations suivantes :

- on introduit l'ensemble de plaquettes 2 solidarisées par les entretoises 4 à l'intérieur de l'enveloppe rigide 10 ;

- on fixe ledit ensemble de plaquettes 2 sur au moins trois cales de positionnement 11 solidaire de la face interne de ladite enveloppe rigide 10 ;

- on bouche les extrémités de l'enveloppe rigide 10 par des moyens appropriés ;

- on fait couler une matière élastomère à l'état liquide à l'intérieur de ladite enveloppe rigide 10, à travers des ouvertures 12 prévues le long de la direction longitudinale de ladite enveloppe rigide 10, lesdites ouvertures 12 étant pratiquées de manière à permettre un écoulement facile entre les plaquettes 2 ; et

- on solidifie ladite matière élastomère, qui forme alors ledit corps protecteur 5 monté directement en position de fonctionnement dans l'enveloppe rigide associée 10.

Dans un second mode de réalisation représenté sur la figure 2, le dispositif électronique 1 comporte en plus, à l'avant du bouclier avant 6, une pièce auxiliaire réalisée sous forme d'une rondelle 13.

Ladite rondelle 13 présente une forme en nid d'abeille, par exemple métallique, comportant en coupe transversale des structures hexagonales adjacentes 14, tel que représenté sur la figure 3.

Par ailleurs, une plaque métallique 15 est prévue entre ledit corps protecteur 5 et ladite rondelle 13.

En raison de sa forme particulière, ladite rondelle 13 contribue efficacement à l'amortissement lors d'un choc, puisque l'écrasement de cette rondelle 13 permet d'augmenter le temps d'arrêt du corps protecteur 5 et de diminuer les contraintes de choc induites.

Ce second mode de réalisation représenté sur la figure 2 est particulièrement avantageux lorsque des chocs très violents, à très haute énergie, sont envisagés.

Cette solution utilise ainsi pour la résistance aux chocs à la fois :

- les frottements entre le corps protecteur 5 et l'enveloppe rigide 10 ;
- la déformation élastique du corps protecteur 5 ; et
- la déformation plastique de la rondelle 13.

## Revendications

1. Dispositif électronique comportant un ensemble de plaquettes (2) porteuses de composants électroniques (3), montées de façon écartée et parallèlement les unes par rapport aux autres, ledit dispositif électronique (1) étant susceptible de résister à des chocs dans une direction déterminée, approximativement orthogonale aux plans desdites plaquettes (2), caractérisé en ce qu'il comporte un corps protecteur (5) en matière élastomère enrobant ledit ensemble de plaquettes (2), ladite matière élastomère remplissant tous les espaces entre lesdites plaquettes (2) et formant au moins un bouclier avant (6), dans le sens des chocs ($\vec{E}$), pour ledit ensemble de plaquettes (2).

2. Dispositif électronique selon la revendication 1, caractérisé en ce que ladite matière élastomère forme un bouclier arrière (7), dans le sens des chocs ($\vec{E}$), pour ledit ensemble de plaquettes (2).

3. Dispositif électronique selon l'une des revendications 1 ou 2, caractérisé en ce que ledit corps protecteur (5) présente une forme générale cylindrique.

4. Dispositif électronique selon l'une des revendications 1 ou 2, caractérisé en ce que ledit corps protecteur (5) présente une forme générale parallélépipédique.

5. Dispositif électronique selon l'une quelconque des revendications précédentes, caractérisé en ce que l'on utilise de la silicone comme matière élastomère.

6. Dispositif électronique selon l'une quelconque des revendications précédentes, caractérisé en ce que ladite matière élastomère est au moins partiellement transparente.

7. Dispositif électronique selon l'une quelconque des revendications précédentes, caractérisé en ce que ledit bouclier avant (6) dudit corps protecteur (5) présente un évidement périphérique (8).

8. Dispositif électronique selon l'une quelconque des revendications 2 à 7, caractérisé en ce que ledit bouclier arrière (7) dudit corps protecteur (5) présente un évidement périphérique (9).

9. Dispositif électronique selon l'une quelconque des revendications 7 ou 8, caractérisé en ce que ledit évidement périphérique (8, 9) est de forme conique.

10. Dispositif électronique selon l'une quelconque des revendications précédentes, caractérisé en ce qu'il comporte au moins une pièce auxiliaire (13) en nid d'abeille, montée à l'avant du corps protecteur (5) dans le sens des chocs ($\vec{E}$).

11. Dispositif électronique selon l'une quelconque des revendications précédentes, caractérisé en ce que ledit corps protecteur (5) est entouré d'une enveloppe rigide (10).

12. Dispositif électronique selon la revendication 11, caractérisé en ce que ladite enveloppe rigide (10) est réalisée en un matériau composite.

13. Procédé pour réaliser le dispositif électronique (1) spécifié sous l'une des revendications 11 ou 12, caractérisé en ce que :

- on introduit ledit ensemble de plaquettes (2) dans ladite enveloppe rigide (10) munie d'ouvertures (12) réparties le long de sa direction longitudinale ;
- on bouche les extrémités de ladite enveloppe rigide (10) ;
- on fait couler une matière élastomère à l'intérieur de ladite enveloppe rigide (10) à travers lesdites ouvertures (12) de sorte que ladite matière élastomère enrobe ledit ensemble de plaquettes (2) et remplit les espaces entre lesdites plaquettes (2) ; et
- on solidifie ladite matière élastomère formant ainsi ledit corps protecteur (5) et au moins ledit bouclier avant (6).

**Patentansprüche**

1. Elektronische Vorrichtung mit einer Gruppe von Platten (2) mit elektronischen Bauteilen (3), die im Abstand parallel zueinander angeordnet sind, wobei die elektronische Vorrichtung (1) in einer bestimmten Richtung annähernd senkrecht zur Ebene der Platten (2) stoßbeständig ist, dadurch gekennzeichnet, daß sie ein Schutzgehäuse (5) aus Elastomer hat, das die Gruppe der Platten (2) umgibt, das Elastomer alle Räume zwischen den Platten (2) ausfüllt und in Richtung der Stöße ($\vec{E}$) für die Gruppe der Platten (2) mindestens eine vordere Abschirmung (6) bildet.

2. Elektronische Vorrichtung nach Anspruch 1, dadurch gekennzeichnet, daß das Elastomer in Richtung der Stöße ($\vec{E}$) für die Gruppe der Platten (2) eine hintere Abschirmung (7) bildet.

3. Elektronische Vorrichtung nach einem der Ansprüche 1 oder 2, dadurch gekennzeichnet, daß das Schutzgehäuse (5) eine allgemein zylindrische Form hat.

4. Elektronische Vorrichtung nach einem der Ansprüche 1 oder 2, dadurch gekennzeichnet, daß das Schutzgehäuse (5) eine allgemein parallelepipedische Form hat.

5. Elektronische Vorrichtung nach einem der obigen Ansprüche, dadurch gekennzeichnet, daß als Elastomer Silicon verwendet wird.

6. Elektronische Vorrichtung nach einem der obigen Ansprüche, dadurch gekennzeichnet, daß das Elastomer zumindest teilweise durchsichtig ist.

7. Elektronische Vorrichtung nach einem der obigen Ansprüche, dadurch gekennzeichnet, daß die vordere Abschirmung (6) des Schutzgehäuses (5) eine Umfangsaussparung (8) hat.

8. Elektronische Vorrichtung nach einem der Ansprüche 2 bis 7, dadurch gekennzeichnet, daß die hintere Abschirmung (7) des Schutzgehäuses (5) eine Umfangsaussparung (9) hat.

9. Elektronische Vorrichtung nach einem der Ansprüche 7 oder 8, dadurch gekennzeichnet, daß die Umfangsaussparung (8, 9) konisch ist.

10. Elektronische Vorrichtung nach einem der obigen Ansprüche, dadurch gekennzeichnet, daß sie mindestens ein wabenförmiges Hilfsteil (13) hat, das vorne am Schutzgehäuse (5) in Richtung der Stöße ($\vec{E}$) angebracht ist.

11. Elektronische Vorrichtung nach einem der obigen Ansprüche, dadurch gekennzeichnet, daß das Schutzgehäuse (5) von einer starren Ummantelung (10) umgeben ist.

12. Elektronische Vorrichtung nach Anspruch 11, dadurch gekennzeichnet, daß die starre Ummantelung (10) aus einem Verbundwerkstoff verwirklicht wird.

13. Verfahren zur Verwirklichung der in einem der Ansprüche 11 oder 12 näher dargestellten elektronischen Vorrichtung (1), dadurch gekennzeichnet, daß:

   - die Gruppe der Platten (2) in die starre Ummantelung (10) eingesetzt wird, die in Längsrichtung verteilte Öffnungen (12) hat;
   - die Enden der starren Ummantelung (10) abgedichtet werden;
   - in die starre Ummantelung (10) durch die Öffnungen (12) ein Elastomer gegossen wird, so daß das Elastomer die Gruppe von Platten (2) umgibt und die Räume zwischen den Platten (2) ausfüllt; und
   - das Elastomer zur Erstarrung gebracht wird, das damit das Schutzgehäuse (5) und zumindest die vordere Abschirmung (6) bildet.

**Claims**

1. An electronic device comprising a set of boards (2) carrying electronic components (3), said boards being mounted so as to be separated from and parallel to one another, said electronic device (1) being capable of withstanding shocks in a defined direction approximately orthogonal to the planes of said boards (2), characterized in that it comprises a protective body (5) made of an elastomeric substance encapsulating said set of boards (2), said elastomeric substance filling all the spaces between said boards (2) and forming at least one front shield (6), in the direction of the shocks ($\vec{E}$), for said set of boards (2).

2. The electronic device as claimed in claim 1, characterized in that said elastomeric substance forms a rear shield (7), in the direction of the shocks ($\vec{E}$), for said set of boards (2).

3. The electronic device as claimed in either of claims 1 and 2, characterized in that said protective body (5) has a cylindrical general shape.

4. The electronic device according to either of claims 1 and 2, characterized in that said protective body (5) has a parallelepipedal general shape.

5. The electronic device as claimed in any one of the preceding claims, characterized in that silicone is used as the elastomeric substance.

6. The electronic device as claimed in any one of the preceding claims, characterized in that said elastomeric substance is at least partially transparent.

7. The electronic device as claimed in any one of the preceding claims, characterized in that said front shield (6) of said protective body (5) has a peripheral recess (8).

8. The electronic device as claimed in any one of claims 2 to 7, characterized in that said rear shield (7) of said protective body (5) a peripheral recess (9).

9. The electronic device as claimed in either of claims 7 and 8, characterized in that said peripheral recess (8, 9) is cone shaped.

10. The electronic device as claimed in any one of the preceding claims, characterized in that it comprises at least one honeycomb auxiliary piece (13) mounted in front of the protective body (5) in the direction of the shocks ($\vec{E}$).

11. The electronic device as claimed in any one of the preceding claims, characterized in that said protective body (5) is surrounded by a rigid casing (10).

12. The electronic device as claimed in claim 11, characterized in that said rigid casing (10) is made of a composite.

13. A process for producing the electronic device (1) specified in either of claims 11 and 12, characterized in that:

- said set of boards (2) is inserted into said rigid casing (10) provided with openings (12) which are distributed along its longitudinal direction;

- the ends of said rigid casing (10) are plugged;

- an elastomeric substance is poured into said rigid casing (10) through said openings (12) so that said elastomeric substance encapsulates said set of boards (2) and fills the spaces between said boards (2); and

- said elastomeric substance solidifies, thus forming said protective body (5) and at least said front shield (6).

FIG.1

FIG.2

FIG.3